(19) Europäisches Patentamt
European Patent Office
Office européen des brevets

(11) **EP 2 713 194 A2**

(12) **EUROPEAN PATENT APPLICATION**

(43) Date of publication:
**02.04.2014 Bulletin 2014/14**

(51) Int Cl.:
***G02B 6/42*** *(2006.01)*

(21) Application number: **13170236.7**

(22) Date of filing: **03.06.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **31.08.2012 JP 2012192522**

(71) Applicant: **FUJITSU LIMITED**
**Kawasaki-shi,**
**Kanagawa 211-8588 (JP)**

(72) Inventors:
• **Shiraishi, Takashi**
**Kanagawa, 211-8588 (JP)**
• **Yagisawa, Takatoshi**
**Kanagawa, 211-8588 (JP)**

(74) Representative: **HOFFMANN EITLE**
**Patent- und Rechtsanwälte**
**Arabellastrasse 4**
**81925 München (DE)**

(54) **Optical module**

(57)    An optical module includes: a light-receiving element configured to receive an optical signal and convert the optical signal to an electrical signal; a transmission line configured to transmit an electrical signal; and an amplifier element configured to amplify an electrical signal that is output from the light-receiving element and transmitted through the transmission line, wherein characteristic impedance of the transmission line connecting the light-receiving element and the amplifier element is higher than input impedance of the amplifier element.

FIG. 1

**Description**

FIELD

The embodiments discussed herein are related to optical modules.

BACKGROUND

In related art, there are optical modules in each of which a planar optical device and an optical waveguide are optically coupled to each other. The planar optical device emits or receives light in a direction substantially perpendicular to a board, and the optical waveguide guides the light in a direction parallel to the board. In optical interconnect technologies employing such optical modules, the radius of light-receiving area in a light-receiving element is being made smaller to reduce floating capacitance of the light-receiving element and achieve a high speed optical transmission of, for example, over 20 Gbps.

Furthermore, there are optical modules each of which is provided with an ellipsoidal spherical mirror or lens disposed at a coupling part of a light-receiving element and an optical waveguide. In such an optical module, the optical waveguide and the light-receiving element with a smaller radius of light-receiving area are optically coupled to each other in an efficient fashion by utilizing a light-collecting function of the ellipsoidal spherical mirror or lens. For example, Japanese Laid-open Patent Publication No. 2001-141965 and Japanese Laid-open Patent Publication No. 2004-241630 discuss such optical modules. However, there is an issue of an increase in cost when the ellipsoidal spherical mirror or lens is added.

The increase in cost may be reduced by using inexpensive optical waveguides that are widely available. However, when a light-receiving element and an optical waveguide are coupled without utilizing the light-collecting function of the ellipsoidal spherical mirror or lens, the radius of light-receiving area does not have to be reduced down to less than the radius of the optical waveguide. Accordingly, it may be difficult to achieve the high speed optical transmission.

When a light-receiving element having a larger radius of light-receiving area is used, frequency characteristics may become less preferable. There is a technology that increases the transmission speed by improving the frequency characteristics. In this technology, a wire is connected to a transmission line transmitting an electrical signal that is output from the light-receiving element. Inductance of the wire and coupling capacitance of the light-receiving element produce a resonance effect, and this resonance effect is utilized to improve the frequency characteristics and increase the transmission speed. For example, Japanese Laid-open Patent Publication No. 2-238678 discusses such a technology.

However, it is highly desirable to adjust the length of the wire at high precision in order to improve the frequency characteristics by using the foregoing resonance effect. This poses a problem of an increase in cost.

SUMMARY

According to an aspect of the embodiment, an optical module includes: a light-receiving element configured to receive an optical signal and convert the optical signal to an electrical signal; a transmission line configured to transmit an electrical signal; and an amplifier element configured to amplify an electrical signal that is output from the light-receiving element and transmitted through the transmission line, wherein characteristic impedance of the transmission line connecting the light-receiving element and the amplifier element is higher than input impedance of the amplifier element.

BRIEF DESCRIPTION OF DRAWINGS

FIG. 1 illustrates an equivalent circuit for one example of an optical module according to an embodiment;

FIG. 2 illustrates modeling of the equivalent circuit of the optical module illustrated in FIG. 1;

FIG. 3 is a diagram illustrating an example of Smith chart for an incident wave reflection coefficient S11 when Z0 is larger than Zin in the circuit illustrated in FIG. 2;

FIG. 4 is a diagram illustrating an exemplary frequency characteristic for an imaginary part of the incident wave reflection coefficient S11 illustrated in FIG. 3;

FIG. 5 is a diagram illustrating an example of Smith chart for the incident wave reflection coefficient S11 when Z0 is less than Zin in the circuit illustrated in FIG. 2;

FIG. 6 is a diagram illustrating an exemplary frequency characteristic for an imaginary part of the incident wave reflection coefficient S11 illustrated in FIG. 5;

FIG. 7 is a diagram illustrating an exemplary frequency characteristic of a transmission characteristic of transmission line;

FIG. 8 is a diagram illustrating an example of a transmission line;

FIG. 9 is a diagram illustrating an exemplary relationship between line width and impedance of a transmission line;

FIG. 10 illustrates another example of the optical module according to an embodiment;

FIG. 11 is a diagram illustrating a cross-section along a cutting line XI-XI of FIG. 10;

FIG. 12 is a diagram illustrating simulation results of a relationship between an incident wave transmission coefficient S21 and Z0 when a transmission line has a length of 1 mm;

FIG. 13 is a diagram illustrating simulation results of a relationship between the incident wave transmission coefficient S21 and Z0 when a transmission line has a length of 1.5 mm;

FIG. 14 is a diagram illustrating an exemplary relationship between a transmission characteristic of transmission line and length of part where no ground electrode is present below a signal electrode;

FIG. 15 is a diagram in which an equivalent circuit of photodiode is added to the optical module illustrated in FIG. 10;

FIG. 16 illustrates still another example of the optical module according to an embodiment;

FIG. 17 is a diagram illustrating a cross-section along a cutting line XVII-XVII of FIG. 16;

FIG. 18 is a diagram illustrating an exemplary relationship between an impedance of transmission line and a gap between a signal electrode and a cathode line path;

FIG. 19 illustrates another example of the optical module according to an embodiment;

FIG. 20 is a diagram illustrating a cross-section along a cutting line XX-XX of FIG. 19;

FIG. 21 is a diagram illustrating an enlarged view of optical coupling part of FIG. 20;

FIG. 22 illustrates another example of the optical module according to an embodiment;

FIG. 23 is a diagram illustrating a cross-section along a cutting line XXIII-XXIII of FIG. 22;

FIG. 24 is a diagram illustrating a model used in analyzing a deformation amount of an optical waveguide;

FIG. 25 is a diagram illustrating a calculation result of a maximum radius of curvature that an optical waveguide may have;

FIG. 26 illustrates another example of the optical module according to an embodiment;

FIG. 27 is a diagram illustrating a cross-section along a cutting line XXVII-XXVII of FIG. 26;

FIG. 28 illustrates another example of the optical module according to an embodiment;

FIG. 29 is a diagram illustrating simulation results of a frequency characteristic of an incident wave transmission coefficient S21 for the optical module illustrated in FIG. 28;

FIG. 30 illustrates another example of the optical module according to an embodiment;

FIG. 31 is a diagram illustrating a cross-section along a cutting line XXXI-XXXI of FIG. 30;

FIG. 32 is a diagram (part 1) illustrating an exemplary manufacturing method of an optical module according to an embodiment;

FIG. 33 is a diagram (part 2) illustrating the exemplary manufacturing method of an optical module according to an embodiment; and

FIG. 34 is a diagram (part 3) illustrating the exemplary manufacturing method of an optical module according to an embodiment.

DESCRIPTION OF EMBODIMENTS

Hereinafter, preferred embodiments of this optical module are described in detail with reference to the attached drawings. Like reference numerals refer like constituting elements throughout the following description of the embodiments, and overlapping descriptions thereof are omitted.

Example of Optical Module

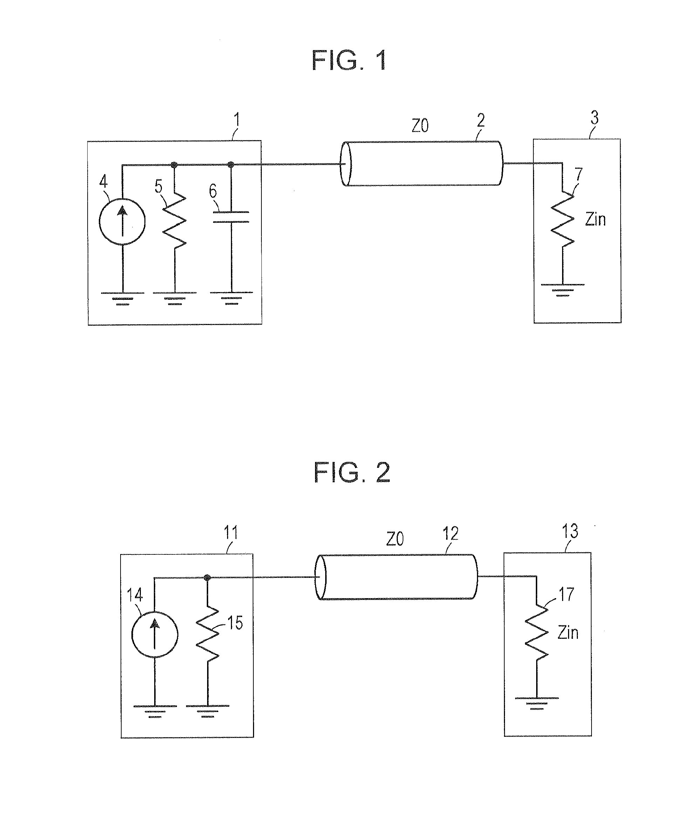

FIG. 1 is a diagram illustrating an equivalent circuit for one example of the optical module according to an embodiment. As illustrated in FIG. 1, the optical module includes a light-receiving element 1, a transmission line 2, and an amplifier element 3.

The light-receiving element 1 receives an optical signal and converts it into an electrical signal. An example of the light-receiving element 1 may be, for example, a photodiode. The photodiode may be represented by a model in which a resistance 5 and a coupling capacitance 6 are connected in parallel to a current source 4 that supplies a current in response to an intensity of an input optical signal. An internal resistance of the photodiode may be, for example, about 100 MΩ, and an output impedance of the photodiode is high.

The transmission line 2 is connected to the light-receiving element 1. The transmission line 2 transmits an electrical signal output from the light-receiving element 1. An example of the transmission line 2 may be, for example, a micro-strip type transmission line. One example of the micro-strip type transmission line is such that a signal electrode composed of an electrically conductive material is formed on a upper surface of a dielectric substrate such as, for example, polyimide, glass epoxy, or the like, and a ground electrode composed of an electrically conductive material is formed on an undersurface of the dielectric substrate.

The amplifier element 3 is connected to the transmission line 2. The amplifier element 3 amplifies an electrical signal that is output from the light-receiving element 1 and transmitted through the transmission line 2. An example of the amplifier element 3 may be, for example, a transimpedance amplifier. The transimpedance amplifier converts a current signal output from the photodiode to a voltage signal. A resistance 7 inside the transimpedance amplifier represents the input impedance of the transimpedance amplifier. This input impedance is composite impedance when viewed from the input side of the transimpedance amplifier.

As described above, the light-receiving element such as, for example, the photodiode is of high impedance. For example, let $Z0$ be the characteristic impedance of the transmission line 2 such as, for example, a micro-strip type transmission line or the like, and $Zin$ be the input impedance of the amplifier element 3 such as, for example, the transimpedance amplifier or the like. In the optical module according to the embodiment, the characteristic impedance $Z0$ of the transmission line 2 is higher than the input impedance $Zin$ of the amplifier element 3.

In this way, because the characteristic impedance $Z0$ of the transmission line 2 is higher than the input impedance $Zin$ of the amplifier element 3, the frequency characteristic of transmission characteristic for the transmission line 2 may be improved. The transmission characteristic of the transmission line 2 may be represented by, for example, an incident wave transmission coefficient of the transmission line 2 that is S21 of S parameter. The incident wave transmission coefficient of the transmission line 2 may be represented by a ratio of the power of an electrical signal output from the transmission line 2 to the amplifier element 3 to the power of an electrical signal input to the transmission line 2 from the light-receiving element 1.

The inventors of the present disclosure have carried out researches and obtained the following findings that allow to improve the frequency characteristic of transmission characteristic for the transmission line 2. Below, the findings will be described.

Description of Findings Obtained by the Inventors of the Present Disclosure

FIG. 2 is a diagram illustrating a modeled equivalent circuit of the optical module illustrated in FIG. 1. In FIG. 2, for sake of simplicity of description, a system is illustrated in which the coupling capacitance 6 (see FIG. 1) of the light-receiving element 1 is omitted and a simple high impedance circuit 11 is connected to a simple low impedance circuit 13 via a transmission line 12. The characteristic impedance of the low impedance circuit 13 is lower than the characteristic impedance of the high impedance circuit 11.

The high impedance circuit 11 is a circuit that models the light-receiving element 1. The high impedance circuit 11 is represented by a model in which a resistance 15 is connected in parallel to a current source 14. The low impedance circuit 13 is a circuit that models the amplifier element 3. The low impedance circuit 13 is modeled by a resistance 17. The characteristic impedance of the low impedance circuit 13 is expressed as $Zin$. The characteristic impedance of the transmission line 12 is expressed as $Z0$.

In high frequency circuits, it is typical to design the characteristic impedance $Z0$ of the transmission line 12 so as that the characteristic impedance $Z0$ of the transmission line 12 becomes equal to the characteristic impedance $Zin$ of the low impedance circuit 13 that serves as a load. In this case, the impedance matching is achieved. Thus, the high impedance circuit 11 sees only the characteristic impedance $Zin$ of the low impedance circuit 13. Accordingly, a high-frequency electrical signal may be transmitted from the high impedance circuit 11 to the low impedance circuit 13 without reflection or loss.

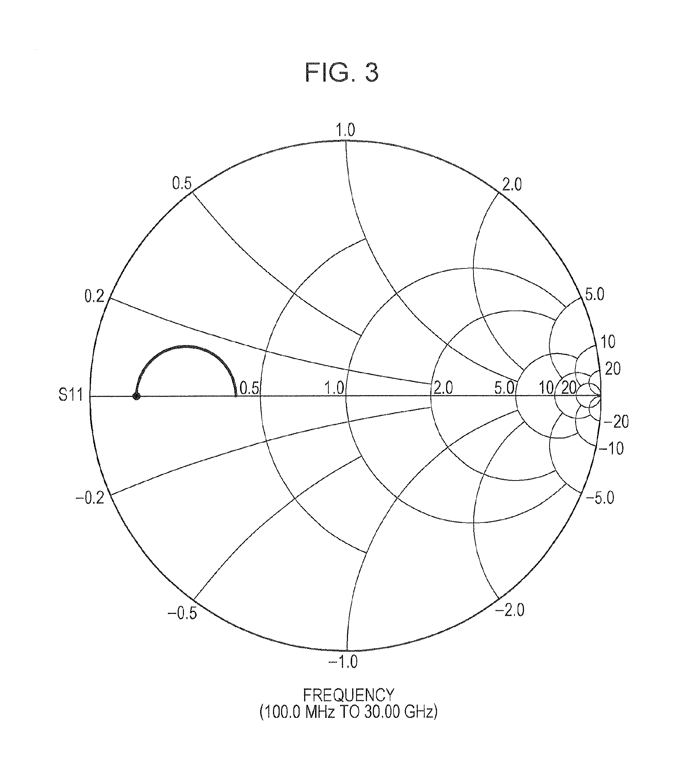

FIG. 3 is a diagram illustrating an example of Smith chart for an incident wave reflection coefficient S11 when $Z0$ is larger than $Zin$ in the circuit illustrated in FIG. 2. The incident wave reflection coefficient S11 is represented by a ratio of the power of an electrical signal reflected back to the high impedance circuit 11 to the power of an electrical signal input to the transmission line 12 from the high impedance circuit 11.

The Smith chart illustrated in FIG. 3 is a result obtained by calculating the incident wave reflection coefficient S11 viewed from the high impedance circuit 11 with a circuit simulator based on the simulation program with integrated circuit emphasis (SPICE). Here, it is assumed that the high impedance circuit 11 has an impedance of 500 $\Omega$, the characteristic impedance $Zin$ of the low impedance circuit 13 is 50 $\Omega$, the characteristic impedance $Z0$ of the transmission line 12 is 100 $\Omega$, and the transmission line 12 has a length of 1.5 mm.

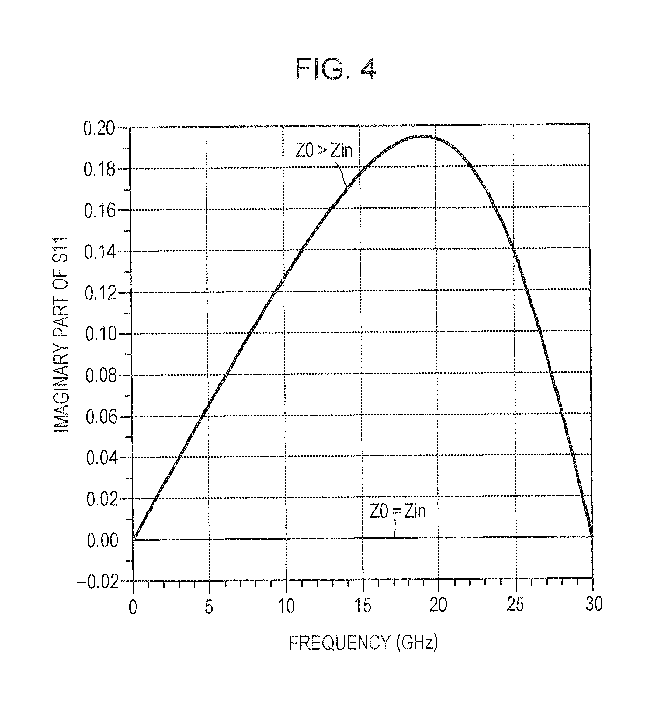

FIG. 4 is a diagram illustrating an exemplary frequency characteristic for an imaginary part of the incident wave reflection coefficient S11 illustrated in FIG. 3. In the characteristic diagram illustrated in FIG. 4, the vertical axis represents the imaginary part of the incident wave reflection coefficient S11, and the horizontal axis represents the frequency. When the imaginary part of the incident wave reflection coefficient S11 is positive, the resistance is inductive reactance that is a coil-like resistance. On the other hand, when the imaginary part of the incident wave reflection coefficient S11 is negative, the resistance is capacitive reactance that is a capacitance-like resistance.

In FIG. 4, when $Z0 = Zin$, the imaginary part of the incident wave reflection coefficient S11 becomes zero. The circuit becomes non-reflective, and neither the inductive nor capacitive component is apparent. On the other hand, when $Z0 > Zin$, it is apparent from FIG. 4 that the inductive feature stands out more clearly around a certain frequency due to impedance miss-matching. According to this feature, there may be an effect in improving the frequency characteristic that is similar to the case where as if a pure coil component such as a wire is inserted.

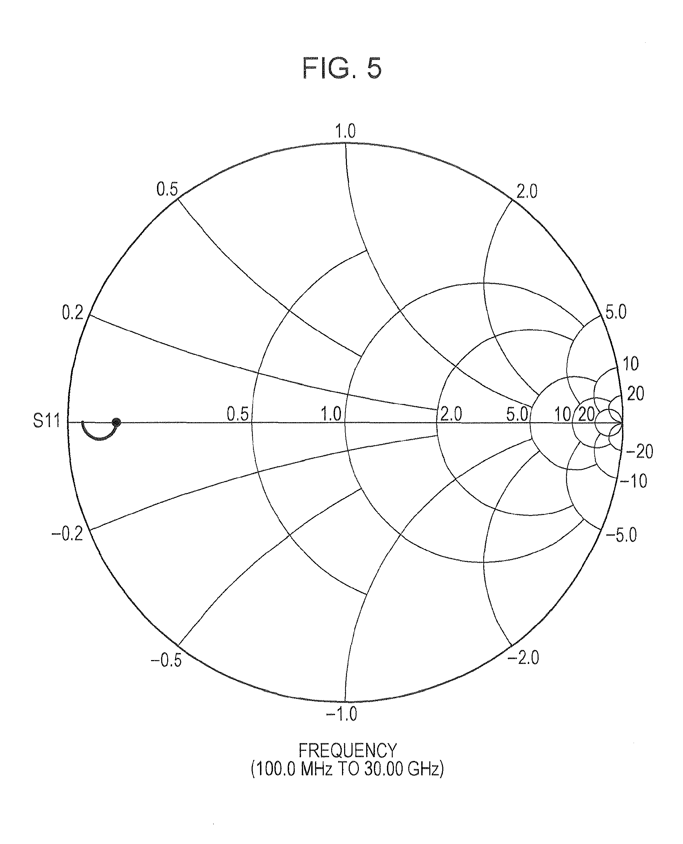

FIG. 5 is a diagram illustrating an example of Smith chart for the incident wave reflection coefficient S11 when Z0 is less than Zin in the circuit illustrated in FIG. 2. The Smith chart illustrated in FIG. 5 is a result obtained by calculating the incident wave reflection coefficient S11 viewed from the high impedance circuit 11 with a circuit simulator based on the simulation program with integrated circuit emphasis (SPICE). Here, it is assumed that the high impedance circuit 11 has an impedance of 500 $\Omega$, the characteristic impedance Zin of the low impedance circuit 13 is 50 $\Omega$, the characteristic impedance Z0 of the transmission line 12 is 30 $\Omega$, and the transmission line 12 has a length of 1.5 mm.

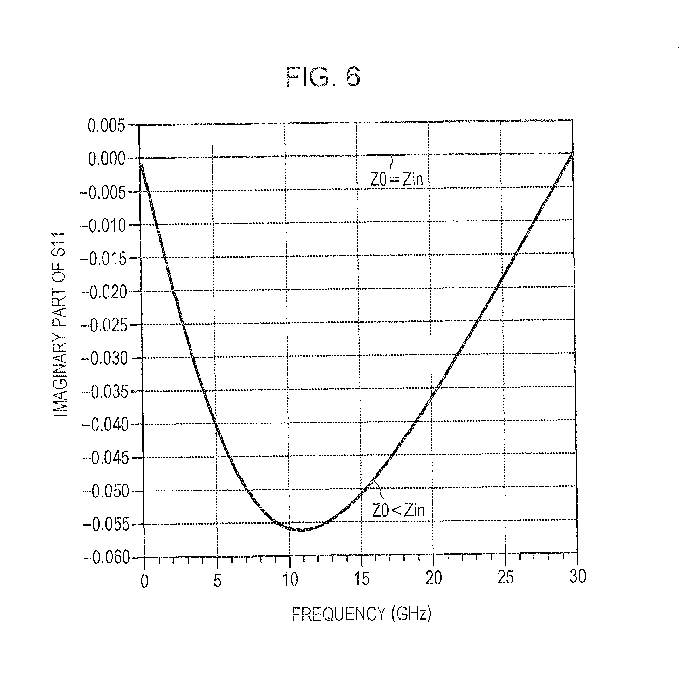

FIG. 6 is a diagram illustrating an exemplary frequency characteristic for an imaginary part of the incident wave reflection coefficient S11 illustrated in FIG. 5. In the characteristic diagram illustrated in FIG. 6, the vertical axis represents the imaginary part of the incident wave reflection coefficient S11, and the horizontal axis represents the frequency. When Z0 < Zin, it is apparent from FIG. 6 that the capacitive feature stands out more clearly. This degrades the frequency characteristic.

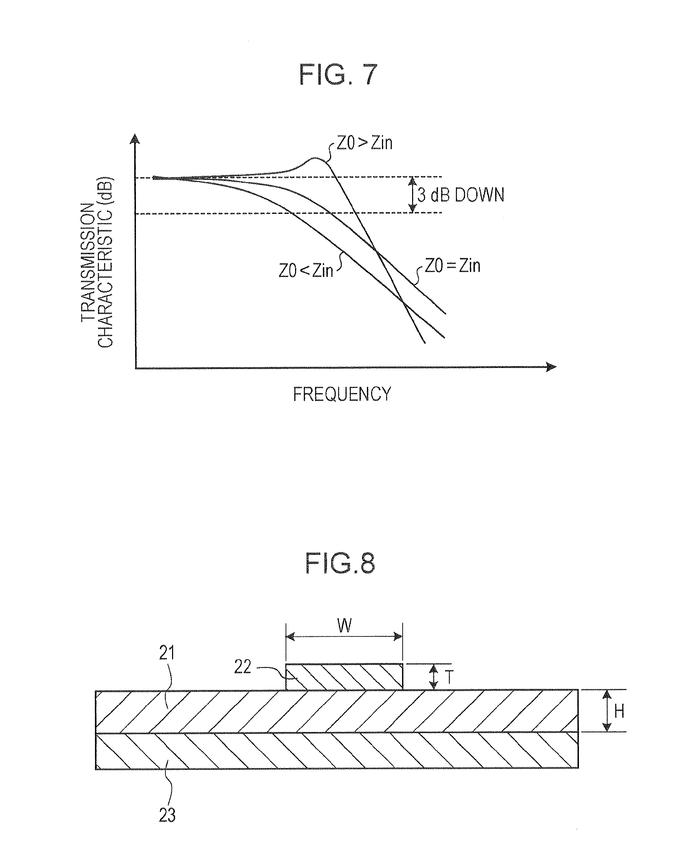

FIG. 7 is a diagram illustrating an exemplary frequency characteristic of transmission characteristic for the transmission line. In the characteristic diagram illustrated in FIG. 7, the vertical axis represents the transmission characteristic, and the horizontal axis represents the frequency. When compared at a frequency where the transmission characteristic is reduced by 3 dB, the frequency characteristic is improved when Z0 > Zin compared to when Z0 = Zin. On the other hand, the frequency characteristic degrades when Z0 < Zin compared to when Z0 = Zin.

Relationship between Line Width and Impedance of Transmission Line

FIG. 8 is a diagram illustrating an example of the transmission line. The transmission line illustrated in FIG. 8 may be, for example, a micro-strip type transmission line. This micro-strip type transmission line may include a signal electrode 22 that is composed of an electrically conductive material and formed on a upper surface of a dielectric substrate 21 such as, for example, polyimide, glass epoxy, or the like, and a ground electrode 23 that is composed of an electrically conductive material and formed on an undersurface of the dielectric substrate 21.

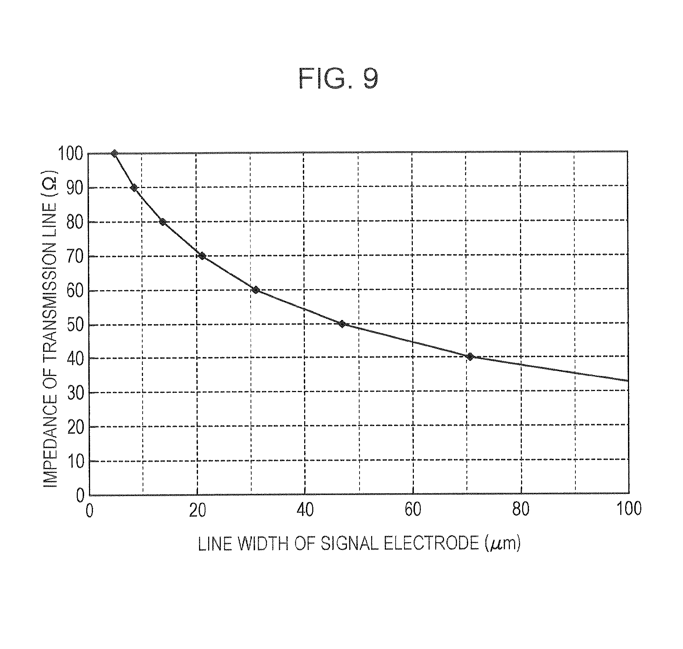

FIG. 9 is a diagram illustrating an exemplary relationship between the line width and the impedance of the transmission line. In the characteristic diagram illustrated in FIG. 9, the vertical axis represents the impedance of transmission line, and the horizontal axis represents the line width of the signal electrode. The characteristic diagram illustrated in FIG. 9 is a result obtained by calculating the impedance of transmission line while varying a width W of the signal electrode 22. Here, it is assumed that the dielectric substrate 21 has a thickness H of 25 $\mu$m, the signal electrode 22 has a thickness T of 20 $\mu$m, and the dielectric substrate 21 has a dielectric constant of 3.3, which is the dielectric constant of polyimide, for example. The characteristic impedance is obtained by analysis of an electromagnetic distribution using a finite element method.

As illustrated in FIG. 9, the impedance of transmission line increases as the width W of the signal electrode 22 becomes narrower. On the other hand, varying the thickness T of the signal electrode 22 provides only a small effect in increasing the impedance of transmission line. Thus, in the present embodiment, no description will be provided with regard to the varying the thickness T of the signal electrode 22. A minimum value of the width W of the signal electrode 22 is determined in response to a limiting value of the line width that may be manufactured. For example, when a flexible printed board is used as the dielectric substrate 21, 30 $\mu$m is the minimum value for the width W of the signal electrode 22 that may be reliably manufactured under a current technology.

It is apparent from FIG. 9 that the impedance of transmission line is 60 $\Omega$ when the width W of the signal electrode 22 is 30 $\mu$m. A typical input impedance of the transimpedance amplifier is 50 $\Omega$. Accordingly, when the input impedance of the transimpedance amplifier is 50 $\Omega$, the impedance of transmission line may be set to 60 $\Omega$ by setting the width W of the signal electrode 22 to 30 $\mu$m. Thus, the condition Z0 > Zin may be satisfied.

In other words, the reduction of the width W of the signal electrode 22 is one way to achieve the condition such that the characteristic impedance Z0 of the transmission line 2 is higher than the input impedance Zin of the amplifier element 3 in the optical module illustrated in FIG. 1. In the future, advancement in manufacturing technology may allow stable manufacturing of the signal electrode 22 with the width W less than 30 $\mu$m. In that case, the impedance of transmission line may be increased over 60 $\Omega$ by further reducing the line width of the signal electrode 22.

Alternatively, the condition Z0 > Zin may be satisfied by forming the ground electrode 23 in such a way that no part of the ground electrode 23 is present below the signal electrode 22. When no part of the ground electrode 23 is present below the signal electrode 22, the distance between the signal electrode 22 and the ground electrode 23 becomes larger in comparison with the case where the ground electrode 23 is present below the signal electrode 22. In this way, the impedance of transmission line may be increased, and the condition Z0 > Zin may be satisfied.

By making the characteristic impedance Z0 of the transmission line 2 higher than the input impedance Zin of the amplifier element 3, the optical module illustrated in FIG. 1 may be able to provide the effect in improving the frequency characteristic similar to that of the case where a coil component is inserted in a signal channel between the light-receiving element 1 and the amplifier element 3. Accordingly, an inexpensive optical module may be provided in comparison with the case where a wire is inserted as the coil component and the length of the wire is adjusted with high precision.

In order to make the characteristic impedance Z0 of the transmission line 2 higher than the input impedance Zin of the amplifier element 3, the width of the signal electrode 22 of the transmission line 2 may be made narrower than the width at which the impedance matching may be achieved, or the signal electrode 22 and the ground electrode 23 may be arranged so as that no part of the ground electrode 23 is present below the signal electrode 22. Both configurations may be achieved by changing mask patterns to be used in manufacturing the transmission line 2 to patterns with which the signal electrode 22 is formed narrower or patterns with which no part of the ground electrode 23 is formed below the signal electrode 22. Accordingly, an inexpensive optical module may be provided.

Another Example of Optical Module

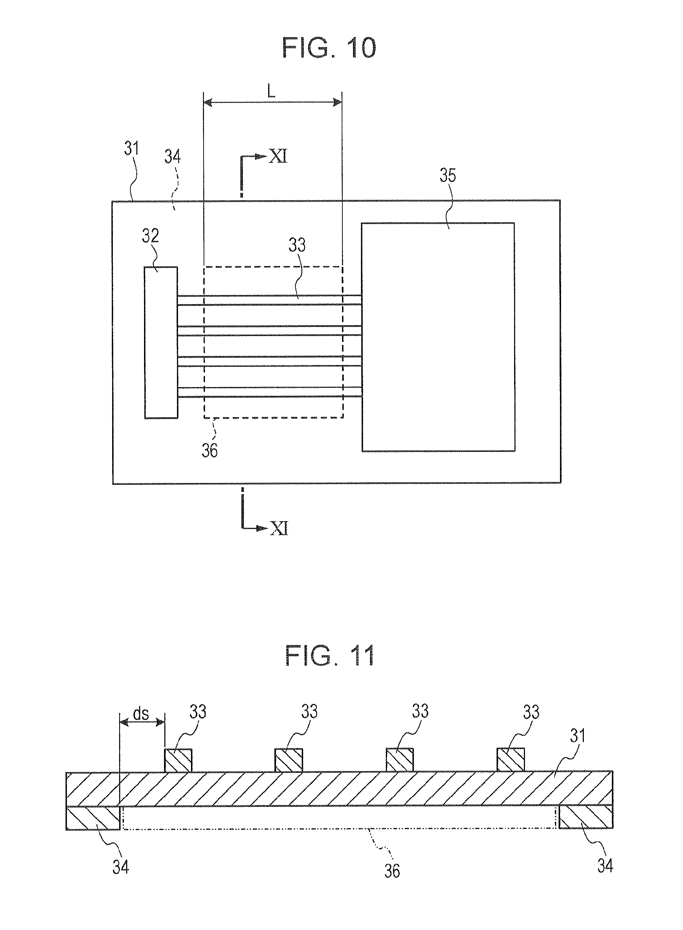

FIG. 10 illustrates another example of the optical module according to an embodiment. FIG. 11 is a diagram illustrating a cross-section along a cutting line XI-XI of FIG. 10. The optical module illustrated in FIG. 10 and FIG. 11 is an example of the optical module in which no ground electrode is present below the signal electrode. As illustrated in FIG. 10 and FIG. 11, the optical module includes a substrate 31, a photodiode array 32, signal electrodes 33, a ground electrode 34, and a transimpedance amplifier 35.

An example of the substrate 31 may be, for example, a flexible printed board that includes a core material such as polyimide or the like. A dielectric layer of the substrate 31 is an example of a dielectric layer of the transmission line.

The photodiode array 32 is an example of the light-receiving element. The photodiode array 32 is mounted on an upper surface of the substrate 31. In the example illustrated in FIG. 10, the photodiode array 32 is provided with, for example, four photodiodes which are not illustrated in the drawing. Each photodiode is mounted so as that its light-receiving plane faces down, namely the light-receiving plane faces the substrate 31. The substrate 31 is formed in such a way that regions of the substrate 31 corresponding to the light-receiving planes of the respective photodiodes are transparent or have their respective openings that go through the substrate 31.

The signal electrode 33 is composed of an electrically conductive material and formed on the upper surface of the substrate 31 from the photodiode array 32 to the transimpedance amplifier 35. In this way, the photodiode array 32 and the transimpedance amplifier 35 are connected via the signal electrode 33. For example, in the example illustrated in FIG. 10, four lines of the signal electrodes 33 are provided in response to the four photodiodes of the photodiode array 32, respectively. The numbers of the photodiodes and the signal electrodes 33 may be three or less, or five or more, or may be set in response to the number of channels. The signal electrode 33 is an example of a first electrically conductive layer of the transmission line.

The ground electrode 34 is composed of an electrically conductive material and formed, for example, on an undersurface of the substrate 31 except in part below the signal electrode 33. In FIG. 10, a region surrounded with a dotted line in a center portion of the substrate 31 illustrates part (region) 36 where the ground electrode 34 is not present. In the example illustrated in FIG. 10, the part 36 where the ground electrode 34 is not present has a rectangle shape. However, the shape of the part 36 is not limited to the rectangle shape. The ground electrode 34 is an example of a second electrically conductive layer of the transmission line. The signal electrodes 33, the dielectric layer of the substrate 31, and the ground electrode 34 form a micro-strip type transmission line.

In FIG. 11, part surrounded by a dashed-two dotted line is the part 36 where the ground electrode 34 is not present below the signal electrode 33 on the undersurface of the substrate 31. The part 36 where the ground electrode 34 is not present below the signal electrode 33 may form an air gap layer or may be filled with a dielectric material. An example of the dielectric material, with which the part 36 where the ground electrode 34 is not present below the signal electrode 33 is filled, may be an epoxy adhesive or other polymer material, for example. On the undersurface of the substrate 31, regions corresponding to the light-receiving planes of the photodiodes of the photodiode array 32 may be formed so as to allow light to pass through. Thus, the region has no part of the ground electrode 34, and may form an air gap layer or may be formed from a transparent material.

In the dielectric layer of the substrate 31 and the ground electrode 34, the region corresponding to the light-receiving plane of each photodiode is formed so as to allow light to pass through. In this way, each photodiode is allowed to receive an optical signal emitted from an optical waveguide formed, for example, on an undersurface side of the substrate 31. On a back surface of the substrate 31, the optical waveguide, which is not illustrated in the figure, is attached to the ground electrode 34 with an adhesive sheet in between them. The optical waveguide may extend in a direction opposite to the signal electrode 33 from a position directly below the photodiode array 32.

As illustrated in FIG. 11, let ds be the distance between an outer edge of the outmost signal electrode 33 and an inner edge of the ground electrode 34. It is desirable to have less variation in impedance among channels of the signal electrodes 33. Thus, it is desirable to have a larger value for the distance ds.

For example, let the substrate 31 be a flexible printed board having a thickness of 25 $\mu$m, the signal electrode 33 has a width of 47 $\mu$m, and the distance between the signal electrodes 33 is 250 $\mu$m. The characteristic impedance of a transmission line formed of each signal electrode 33 is calculated for the case where ds = 50 $\mu$m. Starting from the left in FIG. 11, calculated characteristic impedances of the signal electrodes 33 are 70 $\Omega$, 130 $\Omega$, 130 $\Omega$, and 70 $\Omega$, respectively.

The characteristic impedance of a transmission line formed of each signal electrode 33 is calculated also for the case where ds = 75 $\mu$m. Starting from the left in FIG. 11, calculated characteristic impedances of the signal electrodes 33 are 85 $\Omega$, 130 $\Omega$, 130 $\Omega$, and 85 $\Omega$, respectively. According to those results, it is apparent that the characteristic of transmission line becomes more even when ds = 75 $\mu$m in comparison with the case when ds = 50 $\mu$m. This is because a margin for the impedance increase is smaller as a gap between the signal electrode 33 and the ground electrode 34 becomes wider than a certain level.

In view of the foregoing analysis, it is desirable that the distance ds is equal to 75 $\mu$m or larger. In general, it is desirable that the distance ds is three times the thickness of the substrate 31 or larger, for example.

In high frequency circuits, inductivity may be seen as a resistance component represented by $\omega$L. Thus, a transmission band of transmission line starts to degrade when the inductivity of transmission line becomes too strong. For example, simulation results of the incident wave transmission coefficient S21 of an electrical signal are obtained while varying the characteristic impedance of transmission line. In the simulation, it is assumed that the input impedance Zin of the transimpedance amplifier is 50 $\Omega$, and photodiodes in which a 3 dB band is about 12 GHz are used.

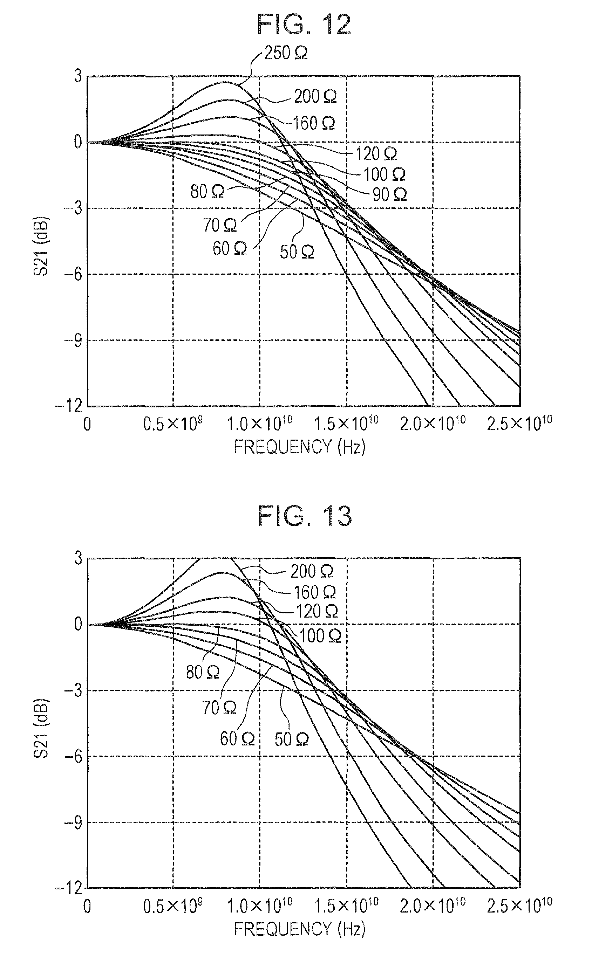

FIG. 12 is a diagram illustrating simulation results of a relationship between the incident wave transmission coefficient S21 and Z0 when the length of transmission line is 1 mm. The vertical axis represents the incident wave transmission coefficient S21, and the horizontal axis represents the frequency. Here, an effect in band expanding is measured by the frequency at which the incident wave transmission coefficient S21 is reduced by 3 dB. From FIG. 12, it is confirmed that the effect in band expanding is present when Z0 is in the range of about 60 $\Omega$ to 250 $\Omega$. When Z0 increases beyond 250 $\Omega$, the inductivity of transmission line becomes too strong. Thus, the transmission band starts to degrade. When Z0 is in the range of about 80 $\Omega$ to 160 $\Omega$, the band reaches substantially the maximum value.

FIG. 13 is a diagram illustrating simulation results of a relationship between the incident wave transmission coefficient S21 and Z0 when the length of transmission line is 1.5 mm. The vertical axis represents the incident wave transmission coefficient S21, and the horizontal axis represents the frequency. Here, the effect in band expanding is measured by the frequency at which the incident wave transmission coefficient S21 is reduced by 3 dB. From FIG. 13, it is confirmed that the effect in band expanding is present when Z0 is in the range of about 60 $\Omega$ to 160 $\Omega$. When Z0 is in the range of about 70 $\Omega$ to 120 $\Omega$, the band reaches substantially the maximum value.

When FIG. 12 and FIG. 13 are compared, it becomes apparent that the range of impedance in which the effect in band expanding may be obtained is wider and the frequency at which the maximum band is achieved is higher in the case where the length of transmission line is 1 mm. Accordingly, it is apparent that the band may be expanded more effectively when the characteristic impedance of transmission line is increased by shortening the length of transmission line.

For example, when the photodiodes and the transimpedance amplifier are flip-chip mounted on the substrate, the minimum value for the length of transmission line is determined by the minimum gap between the photodiodes and the transimpedance amplifier that allows to carry out the flip-chip mounting. When the photodiodes and the transimpedance amplifier are being flip-chip mounted on the substrate, underfill is provided at corresponding locations. The use of underfill increases reliability.

The underfill has a certain length of fillet. Thus, under a current technology, 1 mm is the minimum gap between the photodiodes and the transimpedance amplifier for stable manufacturing. In the future, advancement in manufacturing technology may allow stable flip-chip mounting even when the gap between the photodiodes and the transimpedance amplifier is less 1 mm. In that case, the length of transmission line may be further reduced.

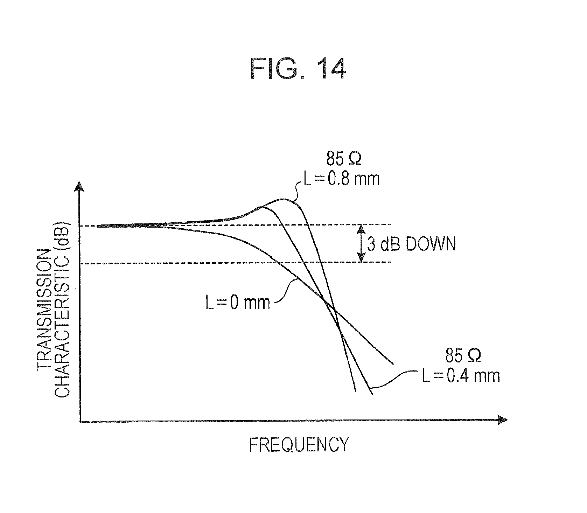

FIG. 14 is a diagram illustrating an exemplary relationship between the transmission characteristic of transmission line and the length of part where no ground electrode is present below the signal electrode. In the characteristic diagram illustrated in FIG. 14, the vertical axis represents the transmission characteristic, and the horizontal axis represents the frequency. In FIG. 10, L is the distance of part 36 where the ground electrode 34 is not present below the signal electrodes 33. Furthermore, the characteristic impedance of transmission line is set to 85 $\Omega$, for example.

When compared at the frequency where the transmission characteristic is reduced by 3 dB, it is apparent from FIG. 14 that the higher inductivity may be obtained as L becomes longer, and thus an effect in widening the band may be obtained. L may be freely changed when designing of the optical module. This provides higher flexibility in designing and allows to use photodiodes having various frequency characteristics.

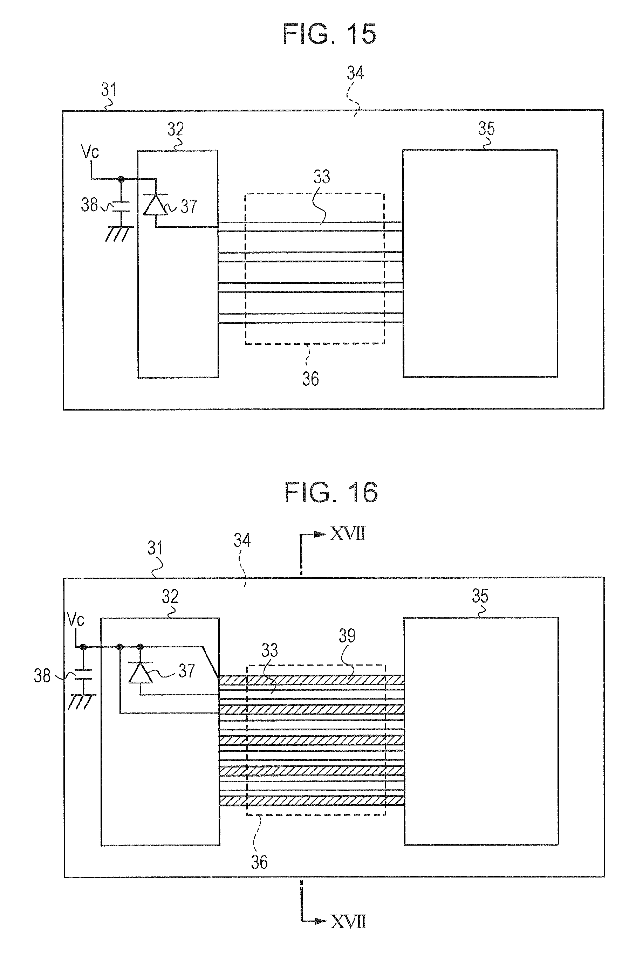

FIG. 15 is a diagram in which an equivalent circuit of photodiode is added to the optical module illustrated in FIG. 10. In FIG. 15, the equivalent circuit of photodiode is added only to one of the channels. However, the same applies to the other channels as well.

As illustrated in FIG. 15, in each photodiode 37 of the photodiode array 32, an anode line is connected to the signal electrode 33, and a reverse bias voltage Vc is applied to a cathode line. A capacitance 38 of, for example, about 100 pF connects the cathode line and the ground electrode 34. In the example illustrated in FIG. 15, the cathode line of the photodiode is routed to a side opposite to the signal electrode 33. However, the cathode line may alternatively be routed to the same side as the signal electrode 33.

According to the optical module illustrated in FIG. 10, since the part 36 where the ground electrode 34 is not present below the signal electrode 33 is formed as an air gap layer or filled with a dielectric material, the distance between the signal electrode 33 and the ground electrode 34 becomes larger in comparison with the case where the ground electrode 34 is present below the signal electrode 33. In this way, the characteristic impedance of transmission line may be made higher than the input impedance of the transimpedance amplifier 35. The ground electrode 34 may be manufactured in such a way that no part of the ground electrode 34 is present below the signal electrode 33 with a mask whose pattern does not allow to form the ground electrode 34 below the signal electrode 33. Accordingly, an inexpensive optical module may be provided.

Another Example of Optical Module

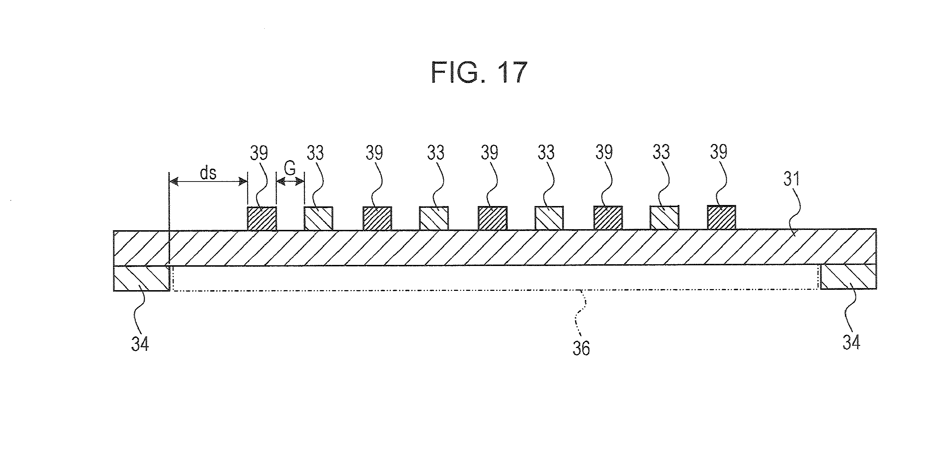

FIG. 16 illustrates another example of the optical module according to an embodiment. FIG. 17 is a diagram illustrating a cross-section along a cutting line XVII-XVII of FIG. 16. The optical module illustrated in FIG. 16 and FIG. 17 is an example of the optical module in which the cathode line of the photodiode is routed to the same side as the signal electrode 33. In FIG. 16, the equivalent circuit of photodiode is added only to one of the channels. However, the same applies to the other channels as well.

As illustrated in FIG. 16 and FIG. 17, in each photodiode 37 of the photodiode array 32, an anode line is connected to the signal electrode 33, and a cathode line is connected to a cathode line path 39 that is formed separately from but along with the signal electrode 33 between the photodiode array 32 and the transimpedance amplifier 35. The cathode line path 39 is composed of an electrically conductive material, and may be formed together with the signal electrodes 33 by patterning when the signal electrodes 33 are manufactured. In FIG. 16 and FIG. 17, hatching is added to the cathode line path 39.

A reverse bias voltage Vc is applied to the cathode line of each photodiode. Here, the cathode line of the photodiode extends to the transimpedance amplifier 35 via the cathode line path 39. Thus, the capacitance 38 to be connected to the cathode line and a source of the reverse bias voltage Vc to be applied to the cathode line may be integrated in the transimpedance amplifier 35.

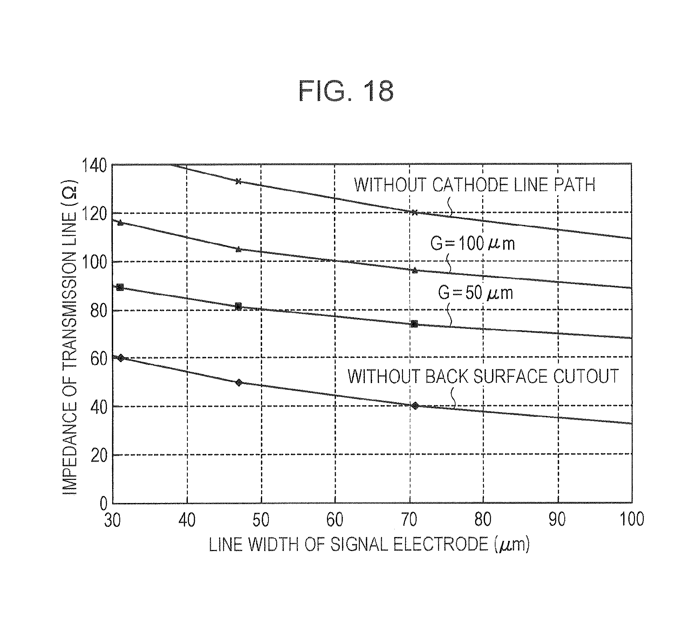

FIG. 18 is a diagram illustrating an exemplary relationship between the impedance of transmission line and a gap between the signal electrode and the cathode line path. In the characteristic diagram illustrated in FIG. 18, the vertical axis represents the impedance of transmission line, and the horizontal axis represents the line width of signal electrode. The characteristic diagram illustrated in FIG. 18 is a result obtained by calculating the impedance of transmission line while varying a gap G between the signal electrode 33 and the cathode line path 39. Here, a flexible printed board with a thickness of 25 $\mu$m is used as the substrate 31, and it is assumed that the distance ds between an outer edge of the outmost cathode line path 39 and an inner edge of the ground electrode 34 is sufficiently large.

In the characteristic drawing illustrated in FIG. 18, "WITHOUT BACK SURFACE CUTOUT" corresponds to the case where the ground electrode 34 is present below the signal electrode 33. "G = 50 $\mu$m", "G = 100 $\mu$m", and "WITHOUT CATHODE LINE PATH" correspond to the cases where the ground electrode 34 is not present below the signal electrode 33. In the cases corresponding to "G = 50 $\mu$m" and "G = 100 $\mu$m", the cathode line path 39 is present. In the case corresponding to " WITHOUT CATHODE LINE PATH", the cathode line path 39 is not present.

It is apparent from FIG. 18 that the characteristic impedance of transmission line surpasses 100 $\Omega$ when the cathode line path 39 is not present whereas the characteristic impedance of transmission line becomes lower when the cathode line path 39 is present by the side of the signal electrode 33. The lowering of the characteristic impedance of transmission line occurs because an electromagnetic field of the signal electrode 33 is being pulled by the cathode line path 39. Furthermore, the characteristic impedance of transmission line becomes lower as the gap G between the signal electrode 33 and the cathode line path 39 decreases. This is because the cathode line path 39 pulls the electromagnetic field of the signal electrode 33 more strongly.

According to the optical module illustrated in FIG. 16, the characteristic impedance of transmission line may be controlled by providing the cathode line path 39 by the side of the signal electrode 33 and adjusting the gap G between the signal electrode 33 and the cathode line path 39. Accordingly, higher flexibility in designing may be provided.

Another Example of Optical Module

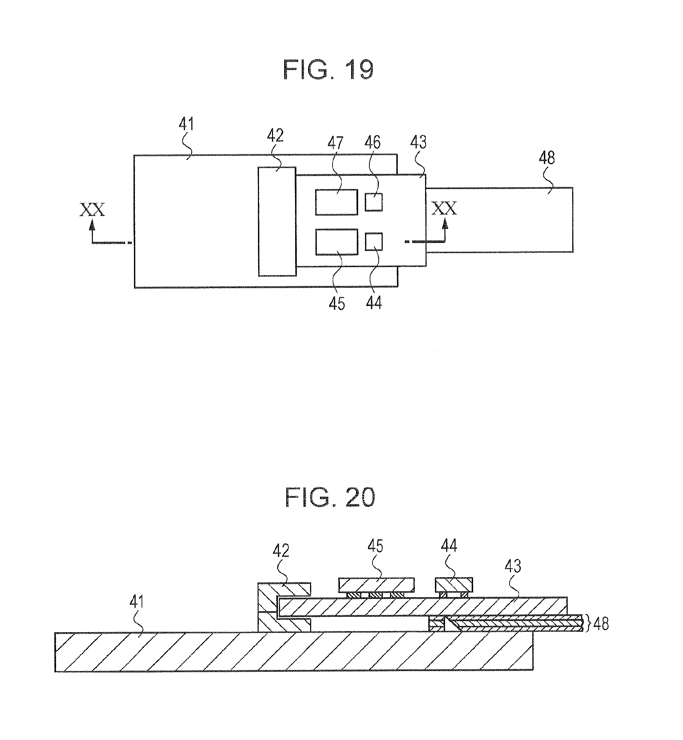

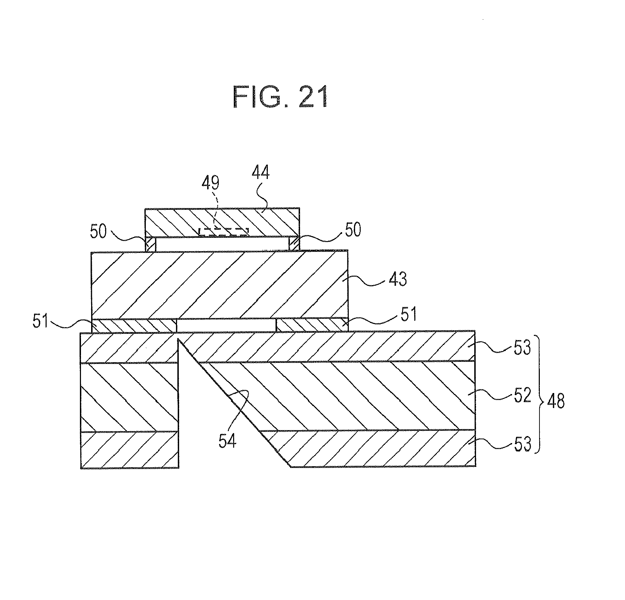

FIG. 19 illustrates another example of the optical module according to an embodiment. FIG. 20 is a diagram illustrating a cross-section along a cutting line XX-XX of FIG. 19. FIG. 21 is a diagram illustrating an enlarged view of optical coupling part of FIG. 20. The optical module illustrated in FIG. 19 to FIG. 21 is an example of a mounted optical module, in which the optical module illustrated in FIG. 10 or FIG. 16 may be used, for example.

As illustrated in FIG. 19 to FIG. 21, the optical module includes a board 41, an electrical connector 42, a flexible printed board 43, a light-receiving element 44, a transimpedance amplifier 45, a light-emitting element 46, a light-emitting element driver integrated circuit (IC) 47, and an optical waveguide 48.

Part of the optical module including the light-receiving element 44 and the transimpedance amplifier 45 may be, for example, an optical module similar to the one illustrated in FIG. 10. In FIG. 19 and FIG. 20, signal electrodes that connect the light-receiving element 44 and the transimpedance amplifier 45 are omitted.

Alternatively, the part of the optical module including the light-receiving element 44 and the transimpedance amplifier 45 may be, for example, an optical module similar to the one illustrated in FIG. 16. In that case, cathode line paths and signal electrodes that connect the light-receiving element 44 and the transimpedance amplifier 45 are omitted from FIG. 19 and FIG. 20.

The light-receiving element 44 is mounted on an upper surface of the flexible printed board 43 through electrodes 50 in such a way that a light-receiving plane 49 faces down. The transimpedance amplifier 45 is mounted on the upper surface of the flexible printed board 43.

The light-emitting element 46 is mounted on the upper surface of the flexible printed board 43 so as that light may be emitted downward. An example of the light-emitting element 46 may be, for example, a laser diode. The light-emitting element driver IC 47 is mounted on the upper surface of the flexible printed board 43. The light-emitting element driver IC 47 outputs a signal to drive the light-emitting element 46. In FIG. 19, a signal electrode that connects the light-emitting element driver IC 47 and the light-emitting element 46 is omitted.

The board 41 may be, for example, a printed board to be built in a computer such as, for example, a server apparatus or a peripheral apparatus to be connected to a computer. The electrical connector 42 is attached to the board 41 and connected to an end of the flexible printed board 43.

The optical waveguide 48 is attached to a ground electrode 51 with an adhesive sheet in between them. Here, the adhesive sheet is not illustrated in the drawing. The ground electrode 51 is formed on a back surface of the flexible printed board 43. The optical waveguide 48 includes a core 52 and a cladding 53. An optical signal travels inside the core 52 while being reflected at a boundary between the core 52 and the cladding 53. A mirror surface 54 is formed at an end of the optical waveguide 48. By reflecting light at the mirror surface 54, the travel direction of light is turned, for example, 90 degrees.

The optical signal traveling inside the core 52 of the optical waveguide 48 is reflected at the mirror surface 54, penetrates through the flexible printed board 43, and enters the light-receiving plane 49 of the light-receiving element 44. An optical signal emitted from the light-emitting element 46 penetrates through the flexible printed board 43, reflects at the mirror surface 54 of the optical waveguide 48, and travels onward through the core 52 of the optical waveguide 48. Parts of the flexible printed board 43 corresponding to the light-receiving element 44 and the light-emitting element 46 may be, for example, made transparent or formed so as to have through-holes to allow light to pass through.

According to the optical module illustrated in FIG. 19, the transmitting and receiving of optical signal may be performed since the light-receiving element 44 and the light-emitting element 46 are included. Accordingly, the optical signal may be transmitted and received between server apparatuses or between a server apparatus and a peripheral apparatus, in each of which the optical module illustrated in FIG. 16 is included.

Another Example of Optical Module

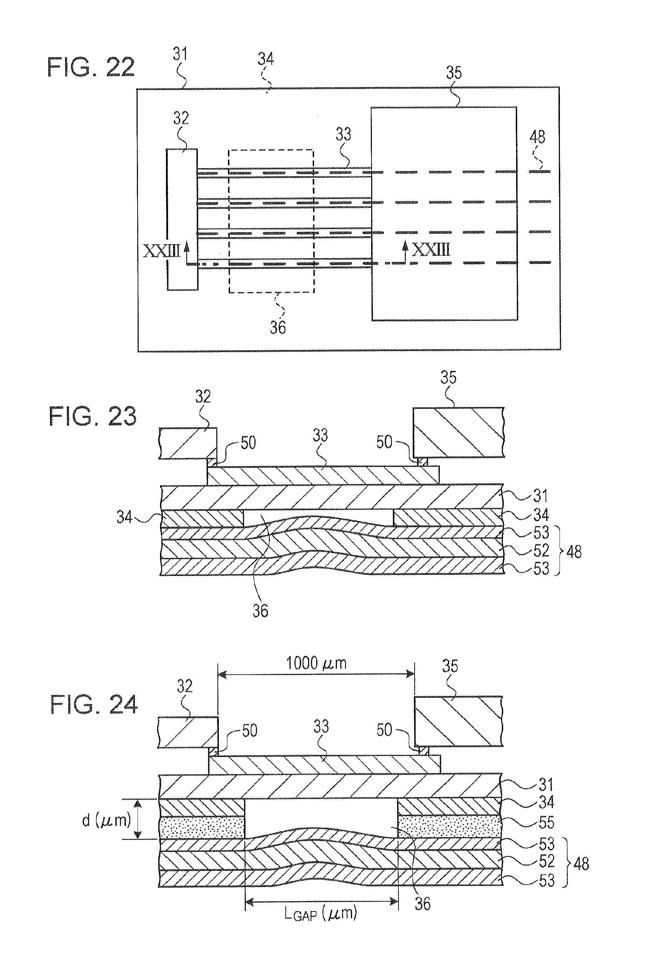

FIG. 22 illustrates another example of the optical module according to an embodiment. FIG. 23 is a diagram illustrating a cross-section along a cutting line XXIII-XXIII of FIG. 22. In the optical module illustrated in FIG. 22 and FIG. 23, the optical waveguide 48 extends along the back surface of the substrate 31 in the same direction as the signal electrode 33 from a position directly below the photodiode array 32, passing through the part 36 where the ground electrode 34 is not present below the signal electrode 33, reaches a transimpedance amplifier 35 side.

In the optical module illustrated in FIG. 22, the optical waveguide 48 is arranged below the signal electrode 33 provided between the photodiode array 32 and the transimpedance amplifier 35. In this case, as is the case with the optical module illustrated in FIG. 10, the characteristic impedance of transmission line may be made higher than the input impedance of the transimpedance amplifier 35. Accordingly, an inexpensive optical module may be provided.

The inventors of the present disclosure performed simulation on the optical module illustrated in FIG. 22. As a result, it is found that the waveguide loss of the optical waveguide 48 degrades in that optical module. The following may be a reason of the degradation in waveguide loss of the optical waveguide 48.

In the optical module illustrated in FIG. 22, the part 36 where the ground electrode 34 is not present below the signal electrode 33 may form an air gap layer or may be filled with a dielectric material. Accordingly, the part 36 where the ground electrode 34 is not present below the signal electrode 33 is softer than the surrounding ground electrode 34. Thus, when the optical waveguide 48 is attached to the flexible printed board by using a manufacturing method that includes press processing such as, for example, lamination, the optical waveguide 48 may sometimes bend at the part 36 where the ground electrode 34 is not present below the signal electrode 33 as illustrated in FIG. 23.

It is known that the optical waveguide loss degrades when part of the optical waveguide has a radius of curvature. For example, in typical polymer optical waveguides, the loss rapidly degrades when the radius of curvature decreases to about 2 mm or less.

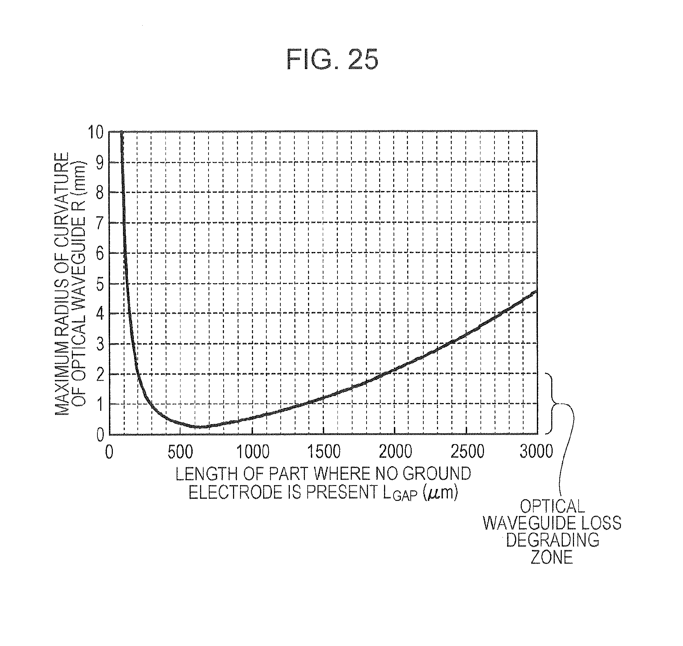

In view of the above, the inventors of the present disclosure analyzed a deformation amount of the optical waveguide 48 with using a model illustrated in FIG. 24. FIG. 24 is a diagram illustrating the model used in analyzing the deformation amount of optical waveguide, and illustrates a cross-section along the cutting line XXIII-XXIII of FIG. 22. As illustrated in FIG. 24, it is assumed that a gap between the photodiode array 32 and the transimpedance amplifier 35 is 1000 $\mu$m, the length of the part 36 where the ground electrode 34 is not present below the signal electrode 33 is $L_{GAP}$ $\mu$m, and a combined thickness of the ground electrode 34 and an adhesive layer 55 is "d" $\mu$m. The adhesive layer 55 may be an adhesive sheet or the like. In the analysis, the maximum radius of curvature that the optical waveguide 48 may have is calculated. FIG. 25 illustrates a calculation result of the maximum radius of curvature that the optical waveguide 48 may have.

As calculation conditions, it is assumed that stress $\sigma$ at the time of attaching the optical waveguide 48 is 1 kgf/mm, Young's modulus E of the optical waveguide 48 is 308 kgf/mm$^2$, a total thickness of the optical waveguide 48 is 100 $\mu$m, and "d" is 60 $\mu$m. With regard to the total thickness of the optical waveguide 48 and the value of "d", the values are selected for ease of manufacturing. Furthermore, it is also assumed that the optical waveguide 48 is a beam with both ends fixed, and that the optical waveguide 48 is fixed to the adhesive sheet in a state where the deformation of the optical waveguide 48 is maximized. Under these assumptions, a one-dimensional deformation simulation of the optical waveguide 48 is performed.

When Y $\mu$m is the maximum displacement amount of the optical waveguide 48, Y may be approximated by the following equation (1), where I mm$^4$ is the second moment of area. In this analysis, the calculation is carried out with a less preferable condition. That is, an optical waveguide sheet having a thickness of 0.1 mm and a width of 0.3 mm is assumed to be used.

$$Y = (1/384) \times (\sigma \times (L_{GAP}/1000)^4) / (I \times E) \times 1000 \ \dots \ (1)$$

The maximum radius of curvature R mm that the optical waveguide 48 may have is expressed by the following equations (2), (3), and (4).

$$R = I \times E / (\sigma \times (L_{GAP}/1000)^2/12) \ \dots \ (2)$$

$$\sigma = 1 \ (\text{when } Y < d) \ \dots \ (3)$$

$$\sigma = 384 \times d \times (I \times E) / 1000 / (L_{GAP}/1000)^4 \ (\text{when } Y > d) \dots \ (4)$$

FIG. 25 is a diagram illustrating the calculation result for the maximum radius of curvature that the optical waveguide may have. In the characteristic diagram illustrated in FIG. 25, the vertical axis represents the maximum radius of curvature R of the optical waveguide, and the horizontal axis represents the length $L_{GAP}$ of the part where no ground electrode is present below the signal electrode. As illustrated in FIG. 25, when $L_{GAP}$ is larger than 1400 $\mu$m, the deformation of the optical waveguide 48 stops at the value of the combined thickness "d" of the ground electrode 34 and the adhesive layer 55. From that point, the maximum radius of curvature of the optical waveguide 48 continues to increase.

However, when $L_{GAP}$ surpasses 1900 $\mu$m, bump portions of the photodiode array 32 and the transimpedance amplifier 35 overlap with the part 36 where the ground electrode 34 is not present below the signal electrode 33. Thus, in such a case, flip-chip mounting of the photodiode array 32 or the transimpedance amplifier 35 on the flexible printed board does not have to be performed.

On the other hand, when $L_{GAP}$ is equal to 200 $\mu$m or less, the deformation amount of the optical waveguide 48 decreases. Thus, the maximum radius of curvature that the optical waveguide 48 may have increases. For example, in polymer optical waveguides, it is known that no excessive loss occurs when the bending radius with respect to a stacking direction of the core 52 and the cladding 53 is equal to 2 mm or larger. Accordingly, it is apparent from FIG. 25 that when $L_{GAP}$ is 200 $\mu$m or less, the bending radius of the optical waveguide 48 becomes 2 mm or larger, and no excessive loss may occur.

Another Example of Optical Module

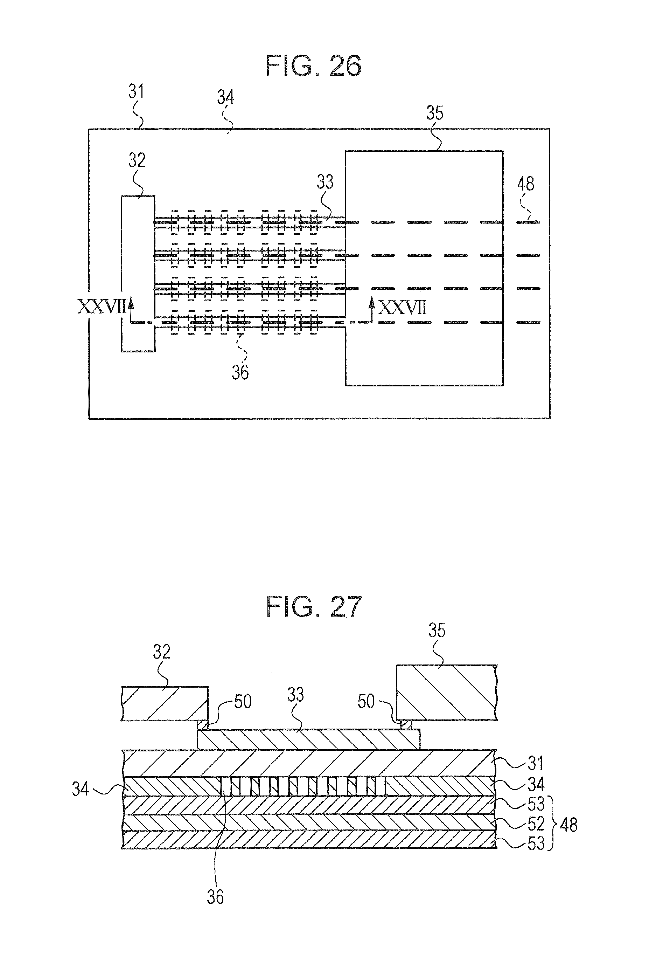

FIG. 26 illustrates another example of the optical module according to an embodiment. FIG. 27 is a diagram illustrating a cross-section along a cutting line XXVII-XXVII of FIG. 26. The optical module illustrated in FIG. 26 and FIG. 27 is capable of reducing the degradation in waveguide loss of the optical waveguide 48 in view of the foregoing findings obtained from the analysis of the deformation amount of the optical waveguide 48.

As illustrated in FIG. 26 and FIG. 27, the part 36 where the ground electrode 34 is not present below the signal electrode 33 is divided into a plurality of divisions. Each division of the part 36 where the ground electrode 34 is not present below the signal electrodes 33 may form an air gap layer or may be filled with a dielectric material. According to the analysis result of the deformation amount of the optical waveguide 48, it is desirable that each division of the part 36 where the ground electrode 34 is not present below the signal electrodes 33 has a length of 200 $\mu$m or less.

In FIG. 27, hatching is added to the ground electrode 34 for easy understanding of the drawing. In an example illustrated in FIG. 26 and FIG. 27, nine divisions of the part 36 where the ground electrode 34 is not present below the signal electrodes 33 are illustrated for each channel. Alternatively, the part 36 may include eight divisions or less, or ten divisions or more for each channel. Furthermore, the part 36 where the ground electrode 34 is not present below the signal electrode 33 does not have to be divided into the same number of divisions for all the channels.

According to the optical module illustrated in FIG. 26, the radius of curvature that the optical waveguide may have increases since the part 36 where the ground electrode 34 is not present below the signal electrode 33 is finely divided into a plurality of divisions. Accordingly, the degradation in waveguide loss of the optical waveguide 48 may be reduced. Furthermore, in each channel, the plurality of divisions are provided in the part 36 where the ground electrode 34 is not present below the signal electrode 33. Thus, similar inductivity may be provided as is the case with the part 36 where the ground electrode 34 is not present below the signal electrode 33 is not divided. Accordingly, the frequency characteristic of transmission characteristic for the transmission line may be improved. A shape of each division of the part 36 where the ground electrode 34 is not present below the signal electrode 33 does not have to be limited to rectangular.

Another Example of Optical Module

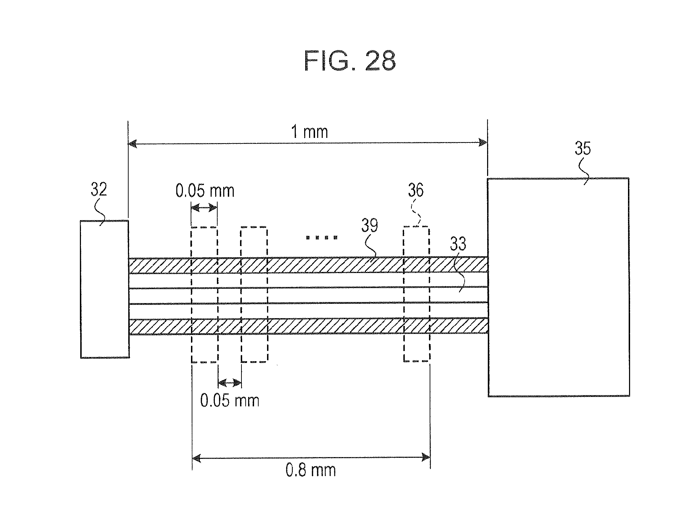

FIG. 28 illustrates another example of the optical module according to an embodiment. In the optical module illustrated in FIG. 28, an anode line of each photodiode of the photodiode array 32 is connected to the signal electrode 33, a cathode line is connected to the cathode line paths 39, and the part 36 where the ground electrode 34 is not present below the signal electrode 33 is divided into a plurality of divisions. The cathode line path 39 is formed along the signal electrode 33 but separately from the signal electrode 33.

In FIG. 28, the signal electrode 33 and the cathode line paths 39 are illustrated only for one channel. However, the same applies to the other channels as well. The optical waveguide that is not illustrated in the drawing may extend in the same direction as the signal electrode 33 from a position directly below the photodiode array 32, or may extend in a direction opposite to the signal electrode 33.

In an example of the optical module illustrated in FIG. 28, it is assumed that the length of the transmission line between the photodiode array 32 and the transimpedance amplifier 35, namely the length of the signal electrode 33 and the cathode line path 39 is 1 mm. Furthermore, it is assumed that each division of the part 36 where the ground electrode 34 is not present below the signal electrode 33 has a length of 0.05 mm. The divisions of the part 36 where the ground electrode 34 is not present below the signal electrode 33 are placed at 0.05 mm interval in a 0.8 mm long block arranged in a center portion between the photodiode array 32 and the transimpedance amplifier 35. Furthermore, in this example, it is assumed that the photodiode array 32 and the transimpedance amplifier 35 are mounted on a substrate that is not illustrated in the drawing, and this substrate has a thickness of 25 $\mu$m. The line width of the signal electrode 33 is 40 $\mu$m, and the distance between the cathode line path 39 and the signal electrode 33 is 50 $\mu$m.

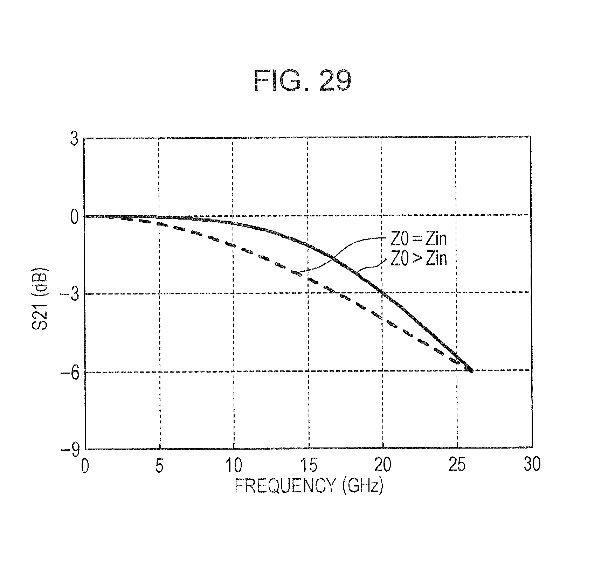

FIG. 29 is a diagram illustrating simulation results of the frequency characteristic of the incident wave transmission coefficient S21 for the optical module illustrated in FIG. 28. The vertical axis represents the incident wave transmission coefficient S21, and the horizontal axis represents the frequency. In the optical module illustrated in FIG. 28, the characteristic impedance Z0 of transmission line is higher than the input impedance of the transimpedance amplifier 35 because of providing the part 36 where the ground electrode 34 is not present below the signal electrode 33. In contrast, Z0 becomes equal to Zin when there is no part 36 where the ground electrode 34 is not present below the signal electrode 33.

It is apparent from FIG. 29 that, judging from the effect in band expanding at the frequency at which the incident wave transmission coefficient S21 is reduced by 3 dB, the frequency characteristic is improved when Z0 > Zin in comparison with the case when Z0 = Zin. In other words, the frequency characteristic of transmission characteristic for the transmission line may also be improved by finely dividing the part 36 where the ground electrode 34 is not present below the signal electrode 33. Thus, according to the optical module illustrated in FIG. 28, the degradation of optical waveguide loss may be reduced and the band may be widened since the part 36 where the ground electrode 34 is not present below the signal electrode 33 is finely divided.

Another Example of Optical Module

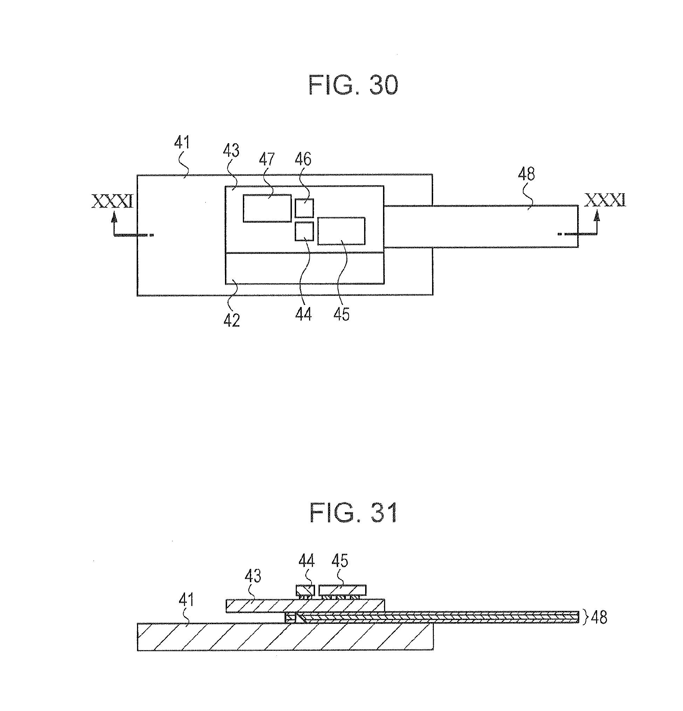

FIG. 30 illustrates another example of the optical module according to an embodiment. FIG. 31 is a diagram illustrating a cross-section along a cutting line XXXI-XXXI of FIG. 30. The optical module illustrated in FIG. 30 and FIG. 31 is an example of a mounted optical module, in which the optical module illustrated in FIG. 22, FIG. 26, or FIG. 28 may be used, for example.

As illustrated in FIG. 30 and FIG. 31, the optical waveguide 48 extends along the back surface of the flexible printed board 43 from a position directly below the light-receiving element 44 to a transimpedance amplifier 45 side and beyond. The light-receiving element 44 and the light-emitting element 46 may be arranged side by side in a direction that crosses an extending direction of the optical waveguide 48 at 90 degrees, for example. Furthermore, the light-emitting element driver IC 47 and the transimpedance amplifier 45 may be arranged on opposing sides of a line along which the light-emitting element 46 and the light-receiving element 44 are arranged side by side.

Part of the optical module including the light-receiving element 44 and the transimpedance amplifier 45 may be, for example, an optical module similar to the one illustrated in FIG. 22 or FIG. 26. In FIG. 30 and FIG. 31, signal electrodes that connect the light-receiving element 44 and the transimpedance amplifier 45 are omitted.

Alternatively, part of the optical module including the light-receiving element 44 and the transimpedance amplifier 45 may be, for example, an optical module similar to the one illustrated in FIG. 28. In that case, cathode line paths and signal electrodes that connect the light-receiver element 44 and the transimpedance amplifier 45 are omitted from FIG. 30 and FIG. 31.

According to the optical module illustrated in FIG. 30, cross-talks between transmission and reception may be reduced by separating the light-emitting element driver IC 47 and the transimpedance amplifier 45. Furthermore, compared with the other case where the light-emitting element 46 and the light-receiving element 44 are arranged side by side, the distance between the light-emitting element driver IC 47 and the transimpedance amplifier 45 may be reduced in the extending direction of the optical waveguide 48. This arrangement may further reduce the size of optical module.

Manufacturing Method of Optical Module

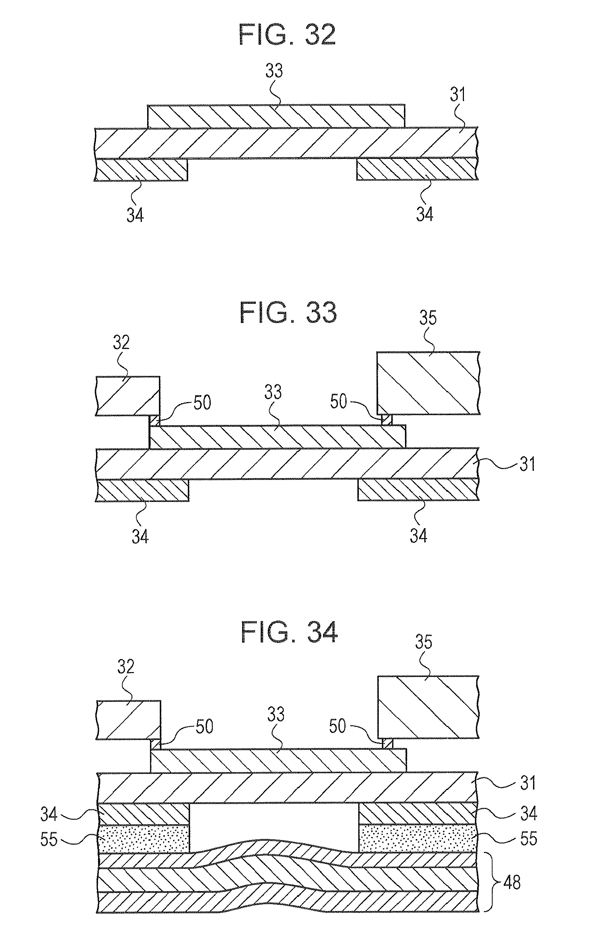

FIG. 32 to FIG. 34 are diagrams illustrating an exemplary manufacturing method of the optical module according to an embodiment. As illustrated in FIG. 32, a substrate is prepared. In the substrate, a copper foil is attached on both sides of a dielectric layer composed of, for example, polyimide or the like. Next, a pattern of transmission line such as the signal electrodes 33 and the cathode line paths and a pattern of the ground electrode 34 are formed by, for example, photolithographic resist transfer and copper foil etching applied on the both sides of the substrate.

Next, as illustrated in FIG. 33, bumps for flip-chip mounting are formed on each of the photodiode array 32 and the transimpedance amplifier 35. Subsequently, devices such as the photodiode array 32, the transimpedance amplifier 35, and the like are mounted on the substrate 31 by using a flip-chip mounting technique such as a technique utilizing ultrasonic waves, a C4 technique, or the like. After the mounting of each device, underfill or sidefill is provided under each device. In FIG. 33, the electrodes 50 are junction portions formed of the bumps for flip-chip mounting.

Next, as illustrated in FIG. 34, the optical waveguide 48 is attached to the back surface of the substrate 31 with the adhesive layer 55 in between. The adhesive layer 55 may be an adhesive sheet or an adhesive agent. When the adhesive sheet is used, part of the adhesive sheet may be cut in advance so as to match a shape of the ground electrode 34, or part of the adhesive sheet does not have to be cut in advance.

According to the foregoing steps, an optical module such as is illustrated in, for example, FIG. 10, FIG. 16, FIG. 22, FIG. 26, or FIG. 28 may be manufactured. Furthermore, an optical module such as is illustrated in, for example, FIG. 19 or FIG. 30 may be manufactured by connecting an optical module such as is illustrated in FIG. 10, FIG. 16, FIG. 22, FIG. 26, or FIG. 28 to an electrical connector of a board in a server apparatus or the like.

**Claims**

1. An optical module, comprising:

   a light-receiving element configured to receive an optical signal and convert the optical signal to an electrical signal;
   a transmission line configured to transmit an electrical signal; and
   an amplifier element configured to amplify an electrical signal that is output from the light-receiving element and transmitted through the transmission line,
   wherein characteristic impedance of the transmission line connecting the light-receiving element and the amplifier element is higher than input impedance of the amplifier element.

2. The optical module according to claim 1, wherein
   the transmission line includes a dielectric layer, a first electrically conductive layer formed into a pattern of the transmission line on a upper surface of the dielectric layer, and a second electrically conductive layer formed on an undersurface of the dielectric layer; and
   of the second electrically conductive layer, a whole or portion of part that corresponds to the pattern of the transmission line connecting the light-receiving element and the amplifier element forms an air gap layer or a dielectric layer.

3. The optical module according to claim 2, further comprising:

   a light-emitting element; and
   a driver element configured to drive the light-emitting element,
   wherein the light-emitting element converts an electrical signal to an optical signal, the electrical signal being output from the driver element and transmitted through the transmission line, and
   wherein the light-emitting element and the light-receiving element are arranged side by side, and the driver element and the amplifier element are arranged opposing sides of a line along which the light-emitting element and the light-receiving element are arranged side by side.

4. The optical module according to claim 3, further comprising:

an optical waveguide that is optically coupled to the light-receiving element and provided on an undersurface of the second electrically conductive layer so as to follow the pattern of the transmission line connecting the light-receiving element and the amplifier element,
wherein the air gap layer or the dielectric layer of the second electrically conductive layer is divided into a plurality of divisions along the pattern of the transmission line connecting the light-receiving element and the amplifier element.

5. The optical module according to claim 4, wherein
each division of the air gap layer or the dielectric layer of the second electrically conductive layer has a length of 200 $\mu$m or less in a direction that follows the pattern of the transmission line connecting the light-receiving element and the amplifier element.

EP 2 713 194 A2

FIG. 1

FIG. 2

# FIG. 3

FREQUENCY
(100.0 MHz TO 30.00 GHz)

# FIG. 4

# FIG. 5

FREQUENCY
(100.0 MHz TO 30.00 GHz)

FIG. 6

# FIG. 7

# FIG.8

FIG. 9

# FIG. 10

# FIG. 11

## FIG. 12

## FIG. 13

FIG. 14

# FIG. 15

# FIG. 16

EP 2 713 194 A2

# FIG. 17

FIG. 18

FIG. 19

FIG. 20

FIG. 21

FIG. 22

FIG. 23

FIG. 24

1000 μm

d (μm)

L_GAP (μm)

# FIG. 25

# FIG. 26

# FIG. 27

FIG. 28

FIG. 29

FIG. 30

FIG. 31

FIG. 32

FIG. 33

FIG. 34

**EP 2 713 194 A2**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001141965 A
- JP 2004241630 A
- JP 2238678 A